# NEW EUROPEAN PATENT SPECIFICATION

(11) **EP 0 284 489 B2**
(45) Date of publication and mention of the opposition decision: **10.04.2002**
(45) Mention of the grant of the patent: 07.02.1996
(21) Application number: 88400598.4
(22) Date of filing: 14.03.1988
(51) Int. Cl.: C23C 14/34, C23C 14/40, C23C 14/48, C01F 11/02, C01F 17/00, C01G 3/02

(54) **Process for depositing a superconducting thin film**
Verfahren zur Abscheidung eines supraleitenden dünnen Filmes
Procédé pour le dépôt d'un film mince supraconducteur

(30) Priority: 14.03.1987 JP 5921487; 16.03.1987 JP 6031787; 18.03.1987 JP 6320387; 18.03.1987 JP 6320487; 18.03.1987 JP 6320587; 18.03.1987 JP 6320687
(43) Date of publication of application: 28.09.1988
(73) Proprietor: SUMITOMO ELECTRIC INDUSTRIES LIMITED, Osaka-shi, Osaka 541 (JP)
(72) Inventor: Fujita, Nobuhiko, 1-1 Koyakita 1-chome Itami-shi Hyogo (JP); Fujimori, Naoji, 1-1 Koyakita 1-chome Itami-shi Hyogo (JP); Itozaki, Hideo, 1-1 Koyakita 1-chome Itami-shi Hyogo (JP); Tanaka, Saburo, 1-1 Koyakita 1-chome Itami-shi Hyogo (JP); Harada, Keizo, 1-1 Koyakita 1-chome Itami-shi Hyogo (JP); Jodai, Tetsuji, 1-1 Koyakita 1-chome Itami-shi Hyogo (JP)
(74) Representative: Hirsch, Marc-Roger

(56) References cited:
- EP-A1- 0 281 444
- EP-A2- 0 277 885
- US-A- 4 316 785
- J. Appl. Phys. 56(8), 15 October 1984, pp. 2330-2332
- Physical Review Letters, vol. 58 no.4, 26 January 1987, pp. 408-410
- Zeitschrift für Physik B - Condensed Matter, vol. 64, 1986, Springer International, Heidelberg; J.G. Bednorz and K.A. Müller: "Possible High Tc Superconductivity in the Ba-La-Cu-O System"
- Journal of Applied Physics, 53(3), March 82, Minoru Suzuki et al.: "Preparation and properties of superconducting BaPb1-xBixO3 thin films by sputtering", pages 1622-1630
- Physical Review Letters, Vol.58, No.9, 2 March 1987, M.K. Wu et al.: "Superconductivity at 93 K in a new mixed-Phase Y-Ba-Cu-o compound System at ambient pressure", pages 908-910
- Japanese Journal of Applied Physics, Vol.22, No.12, December 1983, Minoru Suzuki and Toshiaki Murakami: "Superconducting BaPb1-xBixO3 thin films by RF magnetron Sputtering", pages 1794-1800

## Description

### Field of the invention

The present invention relates to a process for preparing a thin film of superconductor. More particularly, it relates to a process for depositing on a substrate a superconducting thin film of a compound oxide which is uniform in composition and has a higher transition temperature of superconductivity.

### Description of the related art

The superconductivity is a phenomenon which is understood as a phenomenon of phase change under which the electrical resistance become zero and the perfect diamagnetism is observed. Thus, under the superconducting condition, electric current of a very high current density can be delivered without any loss of power.

Therefore, if the superconducting power cable is realized, the power loss of the order of 7 % which is inevitable in the conventional power cables can be reduced greatly. Realization of superconducting coils for generating a very high magnetic field is expected to accelerate development in the field of fusion power generation in which the electric power is consumed beyond its output under the present technology, as well as in the field of MHD power generation or motor-generators. The development of superconductivity is demanded also in the other industrial fields such as in the field or electric power reservation; in the field of transportation for example magnetic levitation trains, or magnetically propelling ships; in the medical field such as high-energy beam radiation unit; or in the field of science such as NMR or high-energy physics.

In addition to the abovementioned power electric applications, the superconducting materials can be used in the field of electronics, for example, as a device using the Josephson effect in which quantum efficiency is observed macroscopically when an electric current is passed through a weak junction arranged between two superconducting bodies. Tunnel junction type Josephson device which is a typical application of the Josephson effect is expected to be a high-speed and low-power consuming switching device owing to smaller energy gap of the superconducting material. It is also expected to utilize the Josephson device as a high sensitive sensor or detector for sensing very weak magnetic field, microwave, radiant ray or the like since variation of electromagnetic wave or magnetic field is reflected in variation of Josephson effect and can be observed as a quantum phenomenon precisely. Development of the superconducting devices is also demanded in the field of high-speed computers in which the power consumption per unit area is reaching to the upper limit of the cooling capacity with increment of the integration density in order to reduce energy consumption.

However, their actual usage have been restricted because the phenomenon of superconductivity can be observed only at very low cryogenic temperatures. Among known superconducting materials, a group of materials having so-called A-15 structure show rather higher Tc (critical temperature of superconductivity) than others, but even the top record of Tc in the case of Nb₃Ge which showed the highest Tc could not exceed 23.2 K at most. This means that liquidized helium (boiling point of 4.2 K) is only one cryogen which can realize such very low temperature of Tc. However, helium is not only a limited costly resource but also require a large-scaled system for liquefaction. Therefore, there had been a strong desire for another superconducting materials having higher Tc. But no material which exceeded the abovementioned Tc had been found for all studies for the past ten years.

Possibility of existence of a new type of superconducting materials having much higher Tc was revealed by Bednorz and Muller who discovered a new oxide type superconductor in 1986 [Z. Phys. B64 (1986) 189]

This new oxide type superconducting material is [La, Ba]₂CuO₄ or [La, Sr]₂CuO₄ which are called as the K₂NiF₄-type oxide. The K₂NiF₄-type oxides show such higher Tc as 30 to 50 K which are extremely higher than the known superconducting materials and hence it becomes possible to use liquidized hydrogen (b,p. = 20.4 K) or liquidized neon (b.p. = 27.3 K) as a cryogen which bring them to exhibit the superconductivity.

However, the above mentioned new type superconducting materials which were just born have been studied and developed only in a form of sintered bodies or as a bulk produced from powders. The superconducting sintered bodies having a form of a bulk inevitably contains non-reacted particles and hence is not uniform in composition and in structure, so that they cannot be used for manufacturing electronics devices.

When the superconducting material is applied to a variety of electronics devices, it is indispensable to prepare a thin film of superconducting material. The superconducting thin film, however, cannot be obtained if composition and structure of the thin film is not controlled precisely.

It is also expected to utilize the superconducting material to produce a superconducting elongated article comprising a supporting member made or metal or tne like in a form of wire, stand, band, tape or the like and a superconducting thin film vacuum-deposited on the supporting member. In this case also, it is necessary to establish technology how to deposit the superconducting thin film in vacuum.

The vapour deposition technique has been used for producing a thin film of superconducting material such as Nb₃Ge and BaPb₁₋ₓBiₓO₃. In case of a thin film of Nb₃Ge, particles or Nb and Ge are sputtered out of several targets each consisting of Nb and Ge respectively and are deposited onto a substrate to form a film composed of Nb₃Ge. Japanese patent laid-open No. 56-109,824 discloses a process for producing a thin film of BaPb₁₋ₓBiₓO₃ by means of sputtering technique. But, only EP-A-0 274 407 being published after the priority date of the present application discloses detailed conditions of physical deposition of the new type compound oxides. EP-A-0 280 273, also published after the priority date of the present application discloses thin film deposition of a superconducting compound oxide by sputtering. The present invention was completed after a variety of experiments and examination which were done for overcome the abovementioned problem.

Therefore, an object of the present invention is to provide a process for producing a superconducting thin film which is uniform in composition and structure and has the higher critical temperature.

### Summary of the Invention

The present invention provide a process for producing a thin film of superconducting oxide, as defined in independent claims 1 2, and 3 respectively of the appended claims. Several embodiments are defined in the dependent claims.

The physical vapor deposition include sputtering, ion plating, vacuum deposition, ion beam deposition and molecular beam deposition, but sputtering is most preferable.

The target preferably contains perovskite type oxide or quasi-perovskite type oxide. The term of quasi-perovskite type oxide means a structure which can be considered to have such a crystal structure that is similar to Perovskite-type oxides and includes an orthorhombically distorted perovskite or a distorted oxygen-deficient perovskite or the like.

According to one preferred embodiment of the present invention, the target as in claim 1 may be a preliminary sintered mass which is obtained by sintering a power mixture of an oxide, carbonate, nitrate or sulfate of Ba; an oxide, carbonate, nitrate or sulfate of one element M selected from a group consisting of Y, La, Gd, Ho Er and Yb; and an oxide, carbonate, nitrate or sulfate of Cu, at a temperature raging from 250 to 1,200 °C, preferably 250 to 1,100 °C. It is more preferable as in claim 3, that the process includes further sintering the abovementioned preliminary sintered material or mass at a temperature raging from 700 to 1,500 °C, preferably from 700 to 1,300 °C.

The term of preliminary sintering means tnat powder material is subjected to heat-treatment or calicinated or sintered to produce a compound oxide.

The target as claimed can be in a form of power as well as in a form of block or mass.

The target as claimed may be composed of a plurality of target segments.

According to another embodiment of the present invention, an atom ratio of Cu/(Ba+M) in the target is selected in a range of from 0.5 to 0.7 and an atom ratio of Ba/(Ba+M) in the target is preferably within a range of from 0.04 to 0.97, preferably from 0.1 to 0.7. The atom ratio of Ba, M and Cu is determined on the basis of the atom ratio of Ba, M and Cu in an objective thin film to be produced. For example, the atom ratio can be adjusted in the function of evaporation rates of Ba, M and Cu on the basis of the atom ratio of Ba, M and Cu in the thin film to be produced. More precisely, the atom ratio of Ba/(Ba+M) in the target is preferably selected from the following ranges for respective elements M:

| Atom ratio | | |
|---|---|---|
| Element "M" | General range | Preferable range |
| Ba/(Ba+Y) | 0.05 - 0.95 | 0.2 - 0.6 |
| Ba/(Ba+La) | 0.04 - 0.96 | 0.1 - 0.4 |
| Ba/(Ba+Gd) | 0.04 - 0.97 | 0.5 - 0.7 |
| Ba/(Ba+Ho) | 0.05 - 0.96 | 0.5 - 0.6 |
| Ba/(Ba+Er) | 0.04 - 0.95 | 0.3 - 0.5 |
| Ba/(Ba+Yb) | 0.05 - 0.96 | 0.5 - 0.6 |

When the abovementioned atom ratios Ba/(Ba+M) are not higher than 0.04 and exceed 0.97, the resulting films deposited do not exhibit desired critical temperatures of superconductivity. The atom ratio of Ba, M and Cu in the target is preferably determined on the basis of the atom ratio of Ba. M and Cu in a thin film to be produced in consideration of evaporation rates of Ba, M and Cu, because the evaporation rates of Ba, M and Cu are not identical with each other and because melting points of respective oxides of Ba, M and Cu which are constituents of the thin film are not identical. In other words, if the atom ratio Ba, M and Cu in the target is not selected properly, the thin film obtained does not have a desired composition which exhibits superconductivity. In case of sputtering technique, the atom ratio in the target may be determined on the basis of sputtering coefficients of oxides of respective elements.

According to another preferred embodiment of the present invention, a substrate on which the thin film is deposited is preferably heated by a heater at a temperature ranging from 184 °C to 1,520 °C, preferably 184 °C to 1,000 °C during the sputtering operation. The temperature at which the substrate is heated is preferably selected from the following ranges for respective systems:

| Temperature of a substrate | | |
|---|---|---|
| Element "M" | General range | Preferable range |
| Y type | 184 - 1,450 | 184 - 975 |
| La type | 285 - 1,480 | 285 - 980 |
| Gd type | 230 - 1,500 | 230 - 990 |
| Ho type | 260 - 1,500 | 260 - 1,000 |
| Er type | 280 - 1,520 | 280 - 980 |
| Yb type | 270 - 1,480 | 270 - 970 |

The substrate may be made of one of materials selected from a group consisting of glass, quartz, silicon, stainless steel and ceramics such as MgO, BaTiO₃, sapphire, YSZ or the like.

According to another preferred embodiment of the present invention, an atmosphere of vaporization contains Ar and O₂. The partial pressure of Ar is preferably adjusted to a range of from 1,33 x 10⁻¹ Pa to 1,33 x 10¹ Pa, preferably 6,67 x 10⁻¹ Pa to 1,33 x 10¹ Pa (1.0 x 10⁻³ to 1 x 10⁻¹ Torr, preferably 5.0 x 10⁻³ to 1 x 10⁻¹ Torr), while the partial pressure of O₂ is preferably adjusted to a range of from 6,67 x 10⁻² Pa to 1,33 x 10¹ Pa, preferably 1,33 x 10⁻¹ Pa to 1,33 x 10¹ Pa (0.5 x 10⁻³ to 1 x 10⁻¹ Torr, preferably 1.0 x 10⁻³ to 1 x 10⁻¹ Torr). When the partial pressure of Ar is not higher than 1,33 x 10⁻¹ Pa (1,0 x 10⁻¹ Torr), the deposition rate become too slow to produce the thin film in industrial scale. When the partial pressure of Ar exceeds 1,33 x 10¹ Pa (1 x10⁻¹ Torr), glow discharge occur, so that deposition of oxide which exhibit a desired superconducting property cannot be obtained. If the partial pressure of O₂ is not higher than 6,67 x 10⁻² Pa (0.5 x 10⁻³ Torr), the resulting thin film does not contain satisfactory amount of perovskite type oxide or quasi-perovskite type oxide because of poor crystal structure. When the partial pressure of O₂ exceeds 1,33 x 10¹ Pa (1 x10⁻¹ Torr), the deposition rate become too slow to produce the thin film in industrial scale. The partial pressure of Ar and O₂ are preferably selected from the following ranges for respective systems:

| The partial pressure of Ar (Torr) 1 Torr = 133,322 Pa | | |
|---|---|---|
| Element "M" | General range | Preferable range |
| Y type | 1.0 x 10⁻³ - 1 x 10⁻¹ | 5.0 x 10⁻³ - 1 x 10⁻¹ |
| La type | 2.0 x 10⁻³ - 9 x 10⁻² | 6.0 x 10⁻³ - 9 x 10⁻² |
| Gd type | 1.0 x 10⁻³ - 2 x 10⁻¹ | 5.0 x 10⁻³ - 2 x 10⁻¹ |
| Ho type | 1.0 x 10⁻³ - 3 x 10⁻¹ | 5.0 x 10⁻³ - 3 x 10⁻¹ |
| Er type | 1.2 x 10⁻³ - 1 x 10⁻¹ | 5.4 x 10⁻³ - 1 x 10⁻¹ |
| Yb type | 1.2 x 10⁻³ - 1 x 10⁻¹ | 5.4 x 10⁻³ - 1 x 10⁻¹ |

| The partial pressure of O₂ (Torr) 1 Torr = 133,322 Pa | | |
|---|---|---|
| Element "M" | General range | Preferable range |
| Y type | 0.7 x 10⁻³ - 8 x 10⁻² | 1.0 x 10⁻³ - 8 x 10⁻² |
| La type | 1.0 x 10⁻³ - 9 x 10⁻² | 1.1 x 10⁻³ - 9 x 10⁻² |
| Gd type | 0.9 x 10⁻³ - 3 x 10⁻¹ | 1.1 x 10⁻³ - 3 x 10⁻¹ |
| Ho type | 0.8 x 10⁻³ - 2 x 10⁻¹ | 1.0 x 10⁻³ - 2 x 10⁻¹ |
| Er type | 0.5x 10⁻³ - -1 x 10⁻¹ | 1.3x 10⁻³ - 1 x 10⁻¹ |
| Yb type | 0.6 x 10⁻³ - 2 x 10⁻¹ | 1.1 x 10⁻³ - 2 x 10⁻¹ |

According to another preferred embodiment, the physical vapor deposition is performed by high-frequency sputtering technique (RF sputtering). The high-frequency power is less than 115 W/cm⁻², preferably less than 15 W/cm⁻². In case of RF sputtering, the speed or rate of deposition increases with increase of the high-frequency power. However, if the high-frequency power exceeds 115 W/cm^{-2,} arc discharge or abnormal discharge is apt to occur. Therefore, the high-frequency power which is less than 115W/cm⁻², preferably less than 15 W/cm⁻² was used in the present invention.

According to further preferred embodiment, the distance between the substrate and the target is adjusted at a value selected from a rage of 3 to 300 mm, preferably 15 to 300 mm. When the distance is too small, it is difficult to produce plasma between the substrate and the target. Particularly, in case of the high-frequency magnetron sputtering technique, the plasma is converged or concentrated in the neighborhood of a magnet positioned behind the target, uniform deposition of the thin film cannot be produced if the distance between the substrate and the target is too small. Therefore, the distance must be larger than the predetermined minimum value. To the contrary, when the distance between the substrate and the target is too large, the deposition rate become too slow to effect practical deposition. Therefore, the distance is preferably adjusted from 3 mm to 300 mm, preferably from 15 mm to 300 mm.

The high-frequency power and the distance between the substrate and the target can be selected from the following ranges for respective systems:

| The high-frequency power and the distance between the substrate and the target | | | |
|---|---|---|---|
| Element "M" | High-frequency power (W/cm2) | Distance (mm) | |
| | | General range | Preferable range |
| Y type | ≦ 95 | 4 - 230 | 15 - 230 |
| La type | ≦ 100 | 3 - 300 | 15 - 300 |
| Gd type | ≦ 103 | 3 - 225 | 16 - 225 |
| Ho type | ≦ 104 | 5 - 215 | 15-215 |
| Er type | ≦ 103 | 4 - 210 | 16-210 |
| Yb type | ≦ 98 | 4 - 221 | 16-220 |

According to a preferred embodiment, the thin film obtained by the abovementioned physical vapor deposition may be heat-treated or annealed additionally in order to reduce the difference between the onset temperature where superconductivity start to be observed and the critical temperature where resistance become zero. This heat-treatment can be carried out at a temperature ranging from 250 °C to 1,700 °C, preferably from 250 °C to 1,200 °C for 0.2 to 7 hours. Through this heat-treatment of the substrate, the thin film is subjected to the same effect as sintering, so that the film is changed to the proper perovskite type oxide or quasi-perovskite type oxide. However, if the temperature of this heat-treatment is too high, it is difficult to control the composition of the deposited film and hence objective the proper perovskite type oxide or quasi-perovskite type oxide cannot be obtained.

The heat-treatment permits to improve the critical temperature (Tc) of the superconducting thin film prepared according to the present invention and also to reduce the difference between the onset temperature where superconductivity starts to be observed and the critical temperature where resistance becomes zero. Thus, atom ratio of oxygen in the deposited thin film can be controlled or adjusted by this heat-treatment in order to improve the superconducting property of the deposited film.

As described above, an object of the heat-treatment is to homogenize the composition of the deposited thin film and to obtain the proper perovskite type oxide or quasi-perovskite type oxide. If the temperature of the heat-treatment is not higher than 250 °C, it is difficult to obtain the objective perovskite type oxide or quasi-perovskite type oxide which possesses the desired critical temperature of superconductivity or it takes extremely longer time to complete the heat-treatment. To the contrary, if the temperature of the heat-treatment exceed 1,700 °C, the objective perovskite type oxide or quasi-perovskite type oxide is too much exhausted or disappeared, resulting in lowering of the critical temperature. In practice, the temperature of the heat-treatment is preferably selected in the following ranges for respective types of "M":

| Temperature of heat-treatment (°C) | | |
|---|---|---|
| Element "M" | General range | Preferable range |
| Y type | 270 - 1,450 | 270 - 1,090 |
| La type | 280 - 1 ,480 | 280 - 1 ,100 |
| Gd type | 380 - 1,700 | 380 - 1,200 |
| Ho type | 250 - 1,650 | 250 - 1,150 |
| Er type | 260 - 1,700 | 260 - 1,200 |
| Yb type | 250 - 1,650 | 250 - 1,100 |

The thin film obtained according to the present invention has the formula:

BapMqCurOx

wherein "M" represents one element selected from a group consisting of Y, La, Gd, Ho Er and Yb and "p", "q", "r" and "x" represent numbers which correspond to atom ratio of the elements of Ba ,M, Cu and O.

Particularly, the thin film is considered one of the following compound oxides or their mixture:

(Ba, M)₂CuO₄₋ₓ ("x" is a number of 1 ≦ x)

(Ba, M)CuO₃₋ₓ ("x" is a number of 1 ≦ x)

or

(Ba, M)₃Cu₂O_{7-*} ("*" is a number of 1 ≦ *)

The thin film obtained according to the present invention can be also considered to have the following compositions or their mixture:
- Y type: Ba_{0.6}Y_{0.4}CuO₃ or
BaY_{0.3}Cu_{0.7}O₃
- La type: Ba_{0.6}La_{0.4}CuO₃ or
BaLa_{0.3}Cu_{0.7}O₃
- Gd type: Ba_{0.6}Gd_{0.4}CuO₃ or
BaGd_{0.3}Cu_{0.7}O₃
- Ho type: Ho_{0.6}Ba_{0.4}CuO₃ or
HoBa_{0.3}Cu_{0.7}O₃
- Er type: Er_{0.6}Ba_{0.4}CuO₃ or
ErBa_{0.3}Cu_{0.7}O₃
- Yb type: Yb_{0.6}Ba_{0.4}CuO₃ or
YbBa_{0.3}Cu_{0.7}O₃

As mentioned above, the target used in the present invention may be a preliminary sintered mass which is obtained by sintering a power mixture of an oxide. carbonate, nitrate or sulfate of Ba; an oxide, carbonate, nitrate or sulfate of one element M selected from a group consisting of Y, La, Gd, Ho Er and Yb; and an oxide, carbonate, nitrate or sulfate of Cu. A finally sintered mass is obtained by further sintering tne abovementioned preliminary sintered material or mass after a pulverising step. It is also possible to use, as the target, a powder which is obtained by pulverizing the abovementioned preliminary sintered mass or finally sintered mass.

When the abovementioned powder of the sintered mass is used as the target, the efficiency of evaporation can be improved and hence higher deposition rate is achieved. The particle size of the powder is preferably selected in a range of from 0.02 to 3 mm, more particularly, can be selected from the following ranges for respective systems or types of element "M":

| Particle size of sintered powder | |
|---|---|
| Element "M" | Particle size (mm) |
| Y type | 0.06 - 3 |
| La type | 0.06 - 3 |
| Gd type | 0.02 - 2 |
| Ho type | 0.03 - 2 |
| Er type | 0.03 - 2 |
| Yb type | 0.04 - 2 |

The target according to the present invention can be also used in the ion plating technique in which an ion beam from an electron gun is directed onto the target.

In fact, adjustment of components which is indispensable to obtain the proper superconducting thin film is facilitated because material of the target is made of sintered mass or powder, and hence it is not scattered by sputtering gas or the ion beam.

It is apparent from the description abovementioned that the process according to the present invention permits to produce a superconducting thin film made of compound oxide having higher Tc than conventional superconducting thin film and hence the superconducting thin film obtained according to the present invention can be utilized advantageously in a applications of thin film devices, such as Matisoo switching elements or Josephson device, Anacker memory device or SQUID (Superconducting Quantum Interference Device).

Now, apparatus which can be used to realize the abovementioned process according to the present invention will be described with reference to attached drawings which are not limitative of the present invention.

### Brief description of the drawings

Figure 1 illustrates an example of an sputtering machine which can be used to carry out the process of the present invention.

Figure 2 shows an illustrative cross section of an embodiment of an ion plating machine which can be used in the process according to the present invention.

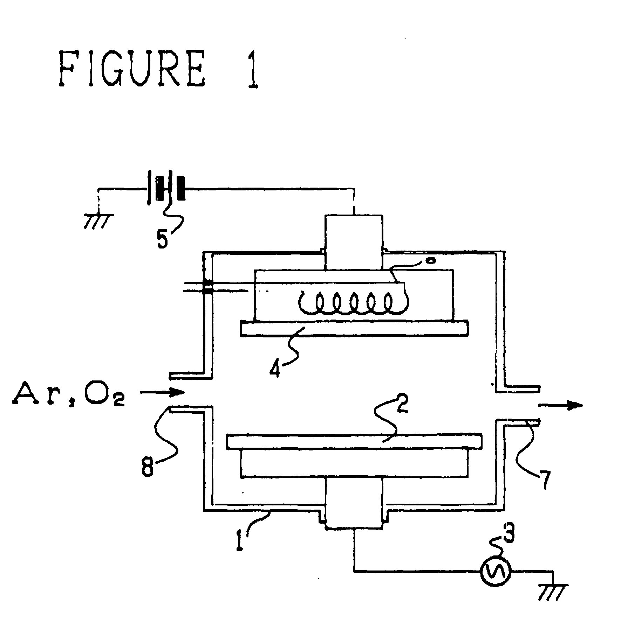

An apparatus illustrated in Figure 1 shows a sputtering machine which is used for carrying out the process according to tne present invention and includes a vacuum chamber or bell jar 1, a material target 2 placed in the vacuum chamber 1, a high-frequency power source 3 connected to the target 2, and a substrate 4 on which the thin film is deposited and being faced to the target 2. A vacuum pump (not shown) connected through a port 7 to the interior of the chamber 1 functions to create vacuum therein.

Bias voltage is impressed on the substrate 4 from a source of high-voltage 5. The substrate 4 is heated by a heater 6 so that the temperature of the substrate is adjustable. The bell jar 1 has a gas inlet 8 for introducing argon gas.

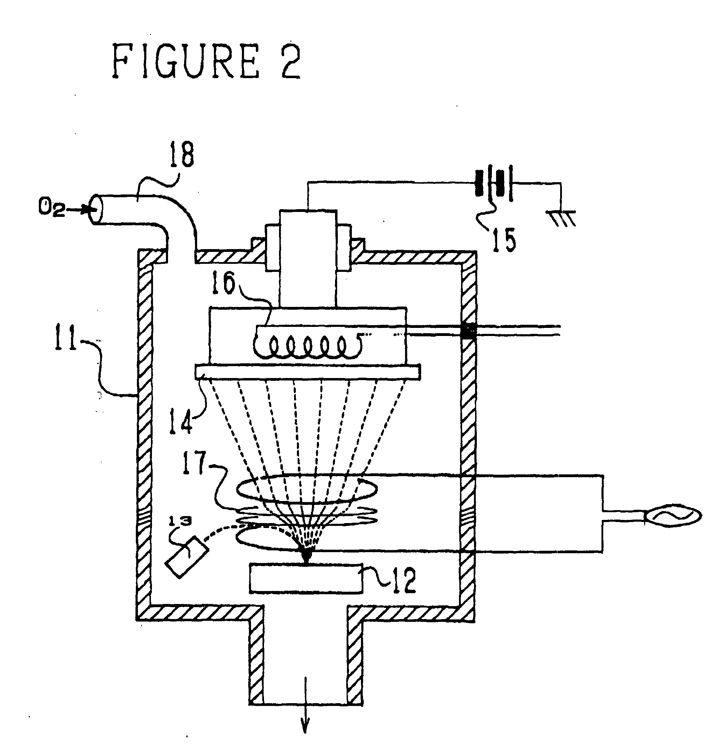

An apparatus illustrated in Figure 2 shows an ion plating machine which can be used for carrying out the process according to the present invention and includes a vacuum chamber or bell jar 11, a material target 12 placed in the vacuum chamber 11, an electron gun 13 placed in the neighborhood of the target 12 for melting and evaporating material of the target 12, and a substrate 14 on which the thin film is deposited and being faced to the target 12. A vacuum pump (not shown) connected to the interior of the chamber 11 functions to create vacuum therein.

Bias voltage is impressed on the substrate 14 from a source of high-voltage 15. The substrate 14 is heated by a heater 16 so that the temperature of the substrate is adjustable. A high-frequency coil 17 is arranged in the bell jar 11 between the target 12 and the substrate 14 in such manner that evaporated particles are enclosed by the coil. The bell jar 11 has a gas inlet 18 for introducing oxygen gas.

Now, embodiments of the process according to the present invention, as well as examples not being embodiments, will be described with reference to illustrative Examples.

### Example 1 (not according to the invention)

A superconducting thin film was produced in a sputtering machine illustrated in Fig. 1.

At first, powders of BaCO₃, Y₂(CO₃)₃, and CuO are mixed uniformly in such proportions that the atom ratio of Ba/(Ba+Y) is 0.4 and the atom ration of Ba/Cu is 2/3 and then compacted. Then, the resulting compacted powder mixture is subjected to a preliminary sintering at 820 °C for 12 hours. The resulting preliminary sintered mass is pulverized and then compacted again. The resulting compacted mass is further sintered finally at 1,080 °C to obtain a target of a sintered body. Sputtering is carried out on a substrate of silicon crystal under the following conditions:

| | |
|---|---|
| Partial pressure of oxygen | 5,33 Pa (4 x 10⁻² Torr) |
| Partial pressure of argon | 4,00 Pa (3 x 10⁻² Torr) |
| Temperature of the substrate | 700 °C |
| Bias voltage imposed on the substrate | - 60 V |
| High-frequency power | 25 W/cm⁻² |
| Distance between substrate and target | 40 mm |

A film of about 1 micron thick is obtained at a deposition rate of 0,3 nm/sec (3 Angstrom/sec). For comparison, the same operation as above is repeated but no oxygen is introduced in the chamber.

To determine electric resistance of the resulting thin film, a pair of electrodes of aluminum are vacuum-deposited on a surface of the thin film at opposite ends of the surface and a pair of lead wires are soldered to the deposited aluminum electrodes.

The result was that the thin film prepared under the partial pressure of oxygen of 5,23 Pa (4 x 10⁻² Torr) according to the present invention showed the onset temperature (from which superconducting phenomenon started to be appeared) of 98 K and the critical temperature (at which the complete superconductor is obtained) of 94 K. On the other hand. in the comparative example in which a thin film is prepared without introducing oxygen. although the resulting thin film showed almost same onset temperature. the electric resistance dropped rather gradually before it became zero at about 9 K. This fact revealed that introduction of oxygen into the chamber for controlling oxygen contents in the thin film during the film formation was critical to obtain a desired superconducting thin film.

### Example 2

In this Example, a powder prepared from the finally sintered body is used as a target. Namely, the finally sintered body obtained in Example 1 is pulverized to prepare the powder having a average particle size of 0.3 mm and sputtering is repeated under the same operation conditions as Example 1 to obtain a superconducting thin film.

In this Example, higher deposition rate of 14 Angstrom/sec. than Example 1 is achieved.

The thin film prepared in this Example 2 in which a target composed of a sintered power showed the onset temperature (from which superconducting phenomenon started to be appeared) of about 97 K and the critical temperature (at which the complete superconductor is obtained) of 92 K.

This fact revealed that the efficiency of film formation can be improved without spoiling the properties of a superconducting thin film substantially.

### Example 3

The same operation as Example 1 is repeated except that proportions of material powders are changed and a preliminary sintered mass is used as a target. Namely, powders of BaCO₃, Y₂(CO₃)₃, and CuO are mixed in such proportions that the atom ratio of Ba:Y:Cu becomes 0.9:0.25:1 and then, the mixture is compacted and sintered preliminary at 400 °C for 12 hours.

A thin film obtained by using a target of the abovementioned preliminary sintered mass showed the onset temperature of about 95 K.

This fact revealed that a superconducting thin film can be produced when a preliminary sintered oxide is used as a target.

### Example 4 (not according to the invention)

The thin film obtained in Example 1 is annealed at 550 °C for 20 minutes under oxygen atmosphere of the partial oxygen pressure of 12,00 Pa (0.9 x 10⁻¹ Torr).

The superconducting transition temperatures of the resulting annealed thin film were measured by the same method as Example 1. The result showed that electric resistance dropped much more sharply than the case of Example 1 and the difference between the onset temperature and the critical temperature was 2 K.

### Example 5 (not according to the invention)

The same operation as Example 1 is repeated except that the final sintering temperature is changed to 920 °C, the high-frequency power is changed to 2.0 W/cm⁻² and a substarate of magnesia (MgO) is used.

The onset temperature and the critical temperature of the resulting thin film measured by the same method as Example 1 were 98 K and 95 K respectively.

### Example 6 (not according to the invention)

A superconducting thin film was produced in a sputtering machine illustrated in Fig. 1.

At first, powders of BaCO₃, La₂(CO₃)₃, and CuO are mixed uniformly in such proportions that the atom ratio of Ba/(Ba+La) is 0.2 and the atom ration of Ba/Cu is 2/3 and then compacted. Then, the resulting compacted powder mixture is subjected to a preliminary sintering at 810 °C for 12 hours . The resulting preliminary sintered mass is pulverized and then compacted again. The resulting compacted mass is further sintered finally at 1,070 °C to obtain a target of a sintered body. Sputtering is carried out on a substrate of silicon crystal under the following conditions

| | |
|---|---|
| Partial pressure of oxygen | 1,33 Pa (1 x 10⁻² Torr) |
| Partial pressure of argon | 1,33 Pa (1 x 10⁻² Torr) |
| Temperature of the substrate | 690 °C |
| Bias voltage imposed on the substrate | - 150 V |
| High-frequency power | 20 W/cm⁻² |
| Distance between substrate and target | 50 mm |

A film of about 1 micron thick is obtained at a deposition rate of 0,5 nm/sec (5 Angstrom/sec). For comparison, the same operation as above is repeated but no oxygen is introduced in the chamber.

To determine electric resistance of the resulting thin film, a pair of electrodes of aluminum are vacuum-deposited on a surface of the thin film at opposite ends of the surface and a pair of lead wires are soldered to the deposited aluminum electrodes.

The result was that the thin film prepared under the partial pressure of oxygen of 1,33 Pa (1 x 10⁻² Torr) according to the present invention showed the onset temperature (from which superconducting phenomenon started to be appeared) of about 60 K and the critical temperature (at which the complete superconductor is obtained) of 51 K. On the other hand, in the comparative example in which a thin film is prepared without introducing oxygen, although the resulting thin film showed almost same onset temperature, the electric resistance dropped rather gradually before it became zero at about 4 K. This fact revealed that introduction of oxygen into the chamber for controlling oxygen contents in the thin film during the film formation was critical to obtain the desired superconducting thin film.

### Example 7

In this Example, a powder prepared from the finally sintered body is used as a target. Namely, the finally sintered body obtained in Example 6 is pulverized to prepare the powder having a average particle size of 0.2 mm and sputtering is repeated under the same operation conditions as Example 1 to obtain a superconducting thin film.

In this Example, higher deposition rate of 0.9 nm/sec (9 Angstrom/sec.) than Example 6 is achieved.

The thin film prepared in thin Example 7 in which target composed of a sintered power showed the onset temperature (from which superconducting phenomenon started to be appeared) of about 55 K and the critical temperature (at which the complete superconductor is obtained) of 49 K.

This fact revealed that the efficiency of film formation can be improved without spoiling the properties of a superconducting thin film substantially.

### Example 8

The same operation as Example 6 is repeated except that proportions of material powders are changed and a preliminary sintered mass is used as a target. Namely, powders of BaCO_{3.} La₂(CO₃)₃, and CuO are mixed in such proportions that the atom ratio of Ba:La:Cu becomes 0.7:0.85:1 and then, the mixture is compacted and sintered preliminary at 400 °C for 12 hours.

A thin film obtained by using a target of the abovementioned preliminary sintered mass showed the onset temperature of about 58 K.

This fact revealed that a superconducting thin film can be produced when a preliminary sintered oxide is used as a target.

### Example 9 (not according to the invention).

The thin film obtained in Example 6 is annealed at 610 °C for 20 minutes under oxygen atmosphere of the partial oxygen pressure of 17,33 Pa (1.3 x 10⁻¹ Torr).

The superconducting transition temperatures of the resulting annealed thin film were measured by the same method as Example 6. The result showed that electric resistance dropped much more sharply than the case of Example 6 and the difference between the onset temperature and the critical temperature was 1 K.

### Example 10 (not according to the invention).

The same operation as Example 6 is repeated except that the final sintering temperature is changed to 930 °C, the high-frequency power is changed to 1.8 W/cm⁻² and a substarate of magnesia (MgO) is used.

The onset temperature and the critical temperature of the resulting thin film measured by the same method as Example 1 were 62 K and 53 K respectively.

### Example 11 (not according to the invention).

A superconducting thin film was produced in a sputtering machine illustrated in Fig. 1.

At first, powders of BaCO₃. Ho₂(CO₃)₃, and CuO are mixed uniformly in such proportions that the atom ratio of Ba/(Ba+Ho) is 0.55 and the atom ration of Ba/Cu is 2/3 and then compacted. Then. the resulting compacted powder mixture is subjected to a preliminary sintering at 830 °C for 12 hours . The resulting preliminary sintered mass is pulverized and then compacted again. The resulting compacted mass is further sintered finally at 1,000 °C to obtain a target of a sintered body. Sputtering is carried out on a substrate of silicon crystal under the following conditions:

| | |
|---|---|
| Partial pressure of oxygen | 1,33 Pa (1 x 10⁻² Torr) |
| Partial pressure of argon | 2,67 Pa (2 x 10⁻² Torr) |
| Temperature of the substrate | 890 °C |
| Bias voltage imposed on the substrate | - 35 V |
| High-frequency power | 8 W/cm⁻² |
| Distance between substrate and target | 20 mm |

A film of about 1 micron thick is obtained at a deposition rate of 0,2 nm/sec (2 Angstrom/sec). For comparison, the same operation as above is repeated but no oxygen is introduced in the chamber.

To determine electric resistance of the resulting thin film, a pair of electrodes of aluminum are vacuum-deposited on a surface of the thin film at opposite ends of the surface and a pair of lead wires are soldered to the deposited aluminum electrodes.

The result was that the thin film prepared under the partial pressure of oxygen of 1,33 Pa (1 x10⁻² Torr) according to the present invention showed the onset temperature (from which superconducting phenomenon started to be appeared) of 106 K and the critical temperature (at which the complete superconductor is obtained) of 100 K. On the other hand, in the comparative example in which a thin film is prepared without introducing oxygen, although the resulting thin film showed almost the same onset temperature, the electric resistance dropped rather gradually before it became zero at about 8 K. This fact revealed that introduction of oxygen into the chamber for controlling oxygen contents in the thin film during the film formation was critical to obtain the desired superconducting thin film.

### Example 12

In this Example, a powder prepared from the finally sintered body is used as a target. Namely, the finally sintered body obtained in Example 11 is pulverized to prepare the powder having a average particle size of 0.2 mm and sputtering is repeated under the same operation conditions as Example 11 to obtain a superoonducting thin film.

In this Example, higher deposition rate of 0.4 nm/sec (4 Angstrom/sec.) than Example 11 is achieved.

The thin film prepared in this Example 12 in which a target composed of a sintered power showed the onset temperature (from which superconducting phenomenon started to be appeared) of about 105 K and the critical temperature (at which the complete superconductor is obtained) of 98 K.

This fact revealed that the efficiency of film formation can be improved without spoiling the properties of the superconducting thin film substantially.

### Example 13

The same operation as Example 11 is repeated except that proportions of material powders are changed and a preliminary sintered mass is used as a target. Namely, powders of BaCO₃, Ho₂(CO₃)₃, and CuO are mixed in such proportions that the atom ratio of Ba:Ho:Cu becomes 0.9:0.85:1 and then, the mixture is compacted and sintered preliminary at 400 °C for 12 hours.

A thin film obtained by using a target of the abovementioned preliminary sintered mass showed the onset temperature of about 103 K.

This fact revealed that a superconducting thin film can be produced when a preliminary sintered oxide is used as a target.

### Example 14 (not according to the invention).

The thin film obtained in Example 11 is annealed at 780 °C for 20 minutes under oxygen atmosphere of the partial oxygen pressure of 14,67 Pa (1.1 x 10⁻¹ Torr).

The superconducting transition temperatures of the resulting annealed thin film were measured by the same method as Example 11. The result showed that electric resistance dropped much more sharply than the case of Example 1 and the difference between the onset temperature and the critical temperature was 3 K.

### Example 15 (not according to the invention).

The same operation as Example 11 is repeated except that the final sintering temperature is changed to 940 °C, the high-frequency power is changed to 3.3 W/cm⁻² and a substarate of magnesia (MgO) is used.

The onset temperature and the critical temperature of the resulting thin film measured by the same method as Example 1 were 107 K and 102 K respectively.

### Example 16 to 18 (not according to the invention).

The same operation as Example 1 is repeated except that Y2(CO3)3 in the material powder is changed to Gd₂ (CO₃)₃ (Example 16), Er₂(CO₃)₃ (Example 17), and Yb₂(CO₃)₃ (Example 18) respectively and that the conditions of sputtering operation are changed or modified to the values shown in Table 1.

The onset temperature (Tci) (from which superconducting phenomenon starts to appear) and the critical temperature (Tcf) (at which the complete superconductor is obtained) of the resulting thin film measured by the same method as Example 1 are also summarized in Table 1.

**Table 1**

| 1Torr = 133,322 Pa - 1 Angstrom = 0.1 nm | | | |
|---|---|---|---|
| | Example | | |
| | 16 | 17 | 18 |
| Element "M" | Gd | Er | Yb |
| Atom ratio Ba/(Ba+M) | 0.6 | 0.4 | 0.55 |
| Atom ratio Ba/Cu | 2/3 | 2/3 | 2/3 |
| Preliminary sintering Temperature (°C) | 810 | 840 | 850 |
| Duration of Preliminary sintering (hr) | 12 | 12 | 12 |
| Final sintering Temperature (°C) | 1,000 | 1,040 | 1,050 |
| Substrate | Si | Si | Si |
| Partial pressure of oxygen (10⁻² Torr) | 1 | 1 | 1 |
| Partial pressure of argon (10⁻² Torr) | 1 | 3 | 3 |
| Temperature of the substrate (°C) | 880 | 910 | 890 |
| Bias voltage imposed on the substrate (V) | -90 | -50 | -70 |
| High-frequency power (W/cm⁻²) | 5 | 12 | 30 |
| Distance between substrate and target (mm) | 70 | 50 | 40 |
| Deposition rate (Angstrom/sec.) | 4 | 3 | 3 |
| Film thickness (micron) | 1 | 1 | 1 |
| Onset temperature (Tci) (K) | 108 | 98 | 95 |
| Critical temp. (Tcf) (K) | 101 | 92 | 85 |

### Example 19 to 21

In these Examples 19 to 21, powders prepared from the finally sintered body are used as respective target. Namely, the finally sintered bodies obtained in Example 16 to 18 are pulverized to prepare powders having average particle sizes shown in Table 2 and sputtering operations are repeated under the same operation conditions as Example 16 to 18 except deposition rates are improved as are shown in Table 2.

The onset temperature (Tc) and the critical temperature (Tcf) at which the complete superconductor is obtained of the resulting thin films measured by the same method as Example 1 are also summarized in Table 2.

**Table 2**

| 1 Angstrom = 0,1 nm | | | |
|---|---|---|---|
| | Example | | |
| | 19 | 20 | 21 |
| Element "M" | Gd | Er | Yb |
| Average particle size (mm) | 0.2 | 0.3 | 0.3 |
| Deposition rate (Angstrom/sec.) | 9 | 5 | 10 |
| Onset temperature (Tci) (K) | 106 | 96 | 94 |
| Critical temp. (Tcf) (K) | 99 | 91 | 85 |

### Example 22 to 24

The same operations as Example 16 to 18 are repeated respectively except that proportions of material powders are changed and targets are changed to preliminary sintered masses. Namely, powders of BaCO₃; Gd₂(CO₃)₃, Er₂ (CO₃)₃ or Yb₂(CO₃)₃; and CuO are mixed in such proportions that the atom ratio or Ba : [Gd, Er or Yb] : Cu becomes respective values shown in the Table 3 and then, the resulting each mixture is compacted and sintered preliminary at 400 °C for 12 hours.

The onset temperature (Tci) of the resulting thin films measured by the same method as Example 1 are also summarized in Table 3.

**Table 3**

| | Example | | |
|---|---|---|---|
| | 22 | 23 | 24 |
| Element "M" | Gd | Er | Yb |

| Compostion of target (atom ratio) | | | |
|---|---|---|---|
| Ba | 0.7 | 0.9 | 0.85 |
| Gd | 0.85 | | |
| Er | | 0.85 | |
| Yb | | | 0.75 |
| Cu | 1.0 | 1.0 | 1.0 |
| Onset temperature (Tci) (K) | 105 | 95 | 92 |

### Example 25 to 27 (not according to present invention)

Each of the thin films obtained in Example 16 to 18 is annealed at a temperature shown in Table 4 for 20 minutes under an oxygen atmosphere of the partial oxygen pressure shown in the Table 4.

The superconducting transition temperatures of the resulting annealed thin films were measured by the same method as Example 16. The result showed that electric resistance dropped much more sharply than the case of Example 16 to 18 and the difference between the onset temperature and the critical temperature of respective thin films were improved as are shown in Table 4.

**Table 4**

| 1 Torr = 133,322 Pa | | | |
|---|---|---|---|
| | Example | | |
| | 25 | 26 | 27 |
| Element "M" in targets | Gd | Er | Yb |
| Partial pressure of oxygen (x 10⁻¹ Torr) | 1.2 | 0.9 | 1.1 |
| Annealing Temperature (°C) | 770 | 710 | 680 |
| Duration of annealing (hr) | 20 | 20 | 20 |
| (Tci) - (Tcf) (K) | 4 | 4 | 83 |

### Example 28 to 30 (not according to the invention).

The same operations as Examples 16 to 18 are repeated except that the final sintering temperature, the high-frequency power are changed to values shown in Table 5 and a substarate of magnesia (MgO) is used for all Examples 28 to 30.

The onset temperatures of the resulting thin films measured by the same method as Example 1 are also shown in Table 5.

## Claims

1. A process for producing a thin film of superconducting oxide having the crystal structure of a perovskite or quasi-perovskite structure by physical vapour deposition on a substrate, **characterised in that** a target used in said physical vapour deposition is made of a compound oxide containing Ba; one element M selected from a group consisting of Y, Gd, Ho, Er, and Yb; and Cu;
**in that** the preparation of said target comprises the steps of:
- preparing a powder mixture of an oxide, carbonate, nitrate or sulfate of Ba; an oxide, carbonate, nitrate or sulfate of one element M selected from a group consisting of Y, Gd, Ho, Er, and Yb; and an oxide, carbonate, nitrate or sulfate of Cu,
- preliminary sintering said powder mixture at a temperature ranging from 250 to 1,200°C into a preliminary sintered material;
and **in that** the thus obtained preliminary sintered material is used as the target.

2. A process for producing a thin film of superconducting oxide having the crystal structure of a perovskite or quasi-perovskite structure by physical vapour deposition on a substrate, **characterised in that** a target used in said physical vapour deposition is made of a compound oxide containing Ba; one element M selected from a group consisting of Y, La, Gd, Ho, Er, and Yb; and Cu;
**in that** the preparation of said target comprises the steps of:
- preparing a powder mixture of an oxide, carbonate, nitrate or sulfate of Ba; an oxide, carbonate, nitrate or sulfate of one element M selected from a group consisting of Y, La, Gd, Ho, Er, and Yb; and an oxide, carbonate, nitrate or sulfate of Cu,
- preliminary sintering said powder mixture at a temperature ranging from 250 to 1,200°C into a preliminary sintered material;
- pulverising the preliminary sintered material into a preliminary sintered powder material;
and **in that** the thus obtained preliminary sintered powder material is used as the target.

3. A process for producing a thin film of superconducting oxide having the crystal structure of a perovskite or quasi-perovskite structure by physical vapour deposition on a substrate, **characterised in that** a target used in said physical vapour deposition is made of a compound oxide containing Ba; one element M selected from a group consisting of Y, La, Gd, Ho, Er, and Yb; and Cu;
**in that** the preparation of said target comprises the steps of:
- preparing a powder mixture of an oxide, carbonate, nitrate or sulfate of Ba; an oxide, carbonate, nitrate or sulfate of one element M selected from a group consisting of Y, La, Gd, Ho, Er, and Yb; and an oxide, carbonate, nitrate or sulfate of Cu,
- preliminary sintering said powder mixture at a temperature ranging from 250 to 1,200°C into a preliminary sintered material;
- pulverising the preliminary sintered material;
- submitting the preliminary sintered material obtained after said pulverisation to a final sintering, carried out at a temperature ranging from 700 to 1,500°C, preferably from 700 to 1,300°C;
- pulverising the finally sintered material obtained by the final sintering into a finally sintered powder material;
and **in that** the thus obtained finally sintered powder material is used as the target.

4. A process claimed in Claim 1, **characterized in that** said target contains perovskite type oxide or quasi-perovskite type oxide.

5. A process claimed in Claim 1 or 4, **characterized in that** said target is composed of a plurality of target segments.

6. A process claimed in Claim 5, **characterized in that** each of said target segments is composed of an oxide of Ba, an oxide of one element M selected from a group consisting of Y, Gd, Ho, Er and Yb, or an oxide of Cu.

7. A process claimed in any one of Claim 1, 4, 5 or 6, **characterized in that** an atom ratio of Ba/(Ba+M) is within a range of from 0.04 to 0.97, wherein M stands for one element M selected from a group consisting of Y, Gd, Ho, Er and Yb.

8. A process claimed in any one of Claim 1, 4, 5, 6 or 7, **characterized in that** an atom ratio of Ba/(Ba+M) is within a range of from 0.1 to 0.7, wherein M stands for one element M selected from a group consisting of Y, Gd, Ho, Er and Yb.

9. A process claimed in Claim 2 or 3, **characterized in that** said target contains perovskite type oxide or quasi-perovskite type oxide.

10. A process claimed in any one of Claim 2, 3 or 9, **characterized in that** said target is composed of a plurality of target segments.

11. A process claimed in Claim 10, **characterized in that** each of said target segments is composed of an oxide of Ba, an oxide of one element M selected from a group consisting of Y, La, Gd, Ho, Er and Yb, or an oxide of Cu.

12. A process claimed in any one of Claim 2, 3, 9, 10 or 11, **characterized in that** an atom ratio of Ba/(Ba+M) is within a range of from 0.04 to 0.97, wherein M stands for one element M selected from a group consisting of Y, La, Gd, Ho, Er and Yb.

13. A process claimed in any one of Claim 2, 3, 9, 10, 11 or 12, **characterized in that** an atom ratio of Ba/(Ba+M) is within a range of from 0.1 to 0.7, wherein M stands for one element M selected from a group consisting of Y, La, Gd, Ho, Er and Yb.

14. A process claimed in any one of Claim 1 to 13, **characterized in that** an atom ratio of Ba, M and Cu in said target is adjusted in the function of evaporation rates of Ba, M and Cu on the basis of the atom ratio of Ba, M and Cu in a thin film to be produced.

15. A process claimed in any one of Claim 1 to 14, **characterized in that** Ar and O₂ are contained in an atmosphere of vaporization, the partial pressure of Ar ranging from 1.33 x 10⁻¹ Pa to 1,33 x 10¹ Pa, preferably 6,67 x 10⁻¹ Pa to 1,33 x 10¹ Pa (1.0 x 10-3 to 1 x 10-1 Torr, preferably 5.0 x 10-3 to 1 x 10-1 Torr).

16. A process claimed in any one of Claim 1 to 15 **characterized in that** the O₂ in the atmosphere of vaporization have the partial pressure ranging from 6,67 x 10⁻² Pa to 1,33 x 10¹ Pa preferably 1,33 x 10⁻¹ Pa to 1,33 x 10¹ (0.5 x 10-3 to 1 x 10-1 Torr, preferably 1.0 x 10-3 to 1 x 10-1 Torr).

17. A process claimed in any one of Claim 1 to 16, **characterized in that** said physical vapor deposition is performed by high-frequency sputtering technique, the power of the high-frequency being less than 115 W/cm⁻², preferably less than 15 W/cm⁻².

18. A process claimed in Claim 17, **characterized in that** said physical vapor deposition is performed by magnetron sputtering.

19. A process claimed in any one of Claim 1 to 18, **characterized in that** the obtained thin film is further heat-treated.

20. A process claimed in 19, **characterized in that** said heat-treatment is carried out at a temperature ranging from 250°C to 1,700°C, preferably from 250° C to 1,200°C.

21. A process claimed in 19 or 20, **characterized in that** said heat-treatment is carried out under a partial pressure of O₂ which is not higher than 6,67 Pa (0.5 x 10-1 Torr).

22. A process claimed in any one of Claim 1 to 21, **characterized in that** a substrate is heated by a heater during the sputtering operation.

23. A process claimed in 22, **characterized in that** said substrate is heated at a temperature ranging from 184°C to 1,520°C, preferably 184°C to 1,000°C during the sputtering operation.

24. A process claimed in any one of Claim 1 to 23, **characterized in that** said substrate is made of one of materials selected from a group consisting of glass, quartz, silicon, stainless steel and ceramics.

25. A process claimed in any one of Claim 1 to 24, **characterized in that** the distance between said substrate and said target is adjusted at a value of from 3 to 300 mm, preferably from 15 to 300 mm.

26. A process claimed in any one of Claim 1 to 16, **characterized in that** said physical vapor deposition is performed by ion plating technique.

27. A process claimed in any one of Claim 1 to 16, **characterized in that** said physical vapor deposition is performed by one of vacuum deposition. ion beam deposition or molecular beam deposition.

## Patentansprüche

1. Verfahren zur Herstellung eines dünnen Films eines supraleitenden Oxids mit einer Kristallstruktur eines Perowskit- oder Quasiperowskit-Aufbaus durch physikalische Abscheidung aus der Dampfphase (PVD) auf einem Substrat, **dadurch gekennzeichnet, dass** bei der physikalischen Abscheidung aus der Dampfphase (PVD) ein Target benutzt wird, welches aus einem Verbundoxid besteht, das Ba; ein Element M aus der aus Y, Gd, Ho, Er und Yb bestehenden Gruppe; und Cu enthält;
und dass die Vorbereitung des Targets die Schritte:
- Vorbereiten einer Pulvermischung eines Oxids, Carbonats, Nitrats oder Sulfats von Ba; eines Oxids, Carbonats, Nitrats oder Sulfats eines der Elemente M aus Y, Gd, Ho, Er und Yb bestehenden Gruppe; und eines Oxids, Carbonats, Nitrats oder Sulfats von Cu,
- Vorsintern dieser Pulvermischung bei einer Temperatur im Bereich von 250 bis 1200 °C zu einem vorgesinterten Werkstoff; umfasst, und dass der so gewonnene und vorgesinterte Werkstoff als Target benutzt wird.

2. Verfahren zur Herstellung eines dünnen Films eines supraleitenden Oxids mit einer Kristallstruktur eines Perowskit- oder Quasiperowskit-Aufbaus durch physikalische Abscheidung aus der Dampfphase (PVD) auf einem Substrat, **dadurch gekennzeichnet, dass** bei der physikalischen Abscheidung aus der Dampfphase (PVD) ein Target benutzt wird, welches aus einem Verbundoxid besteht, das Ba; ein Element M aus der aus Y, Gd, Ho, Er und Yb bestehenden Gruppe; und Cu enthält;
und dass die Vorbereitung des Targets die Schritte:
- Vorbereiten einer Pulvermischung eines Oxids, Carbonats, Nitrats oder Sulfats von Ba; eines Oxids, Carbonats, Nitrats oder Sulfats eines der Elemente M aus Y, Gd, Ho, Er und Yb bestehenden Gruppe; und eines Oxids, Carbonats, Nitrats oder Sulfats von Cu,
- Vorsintern dieser Pulvermischung bei einer Temperatur im Bereich von 250 bis 1200 °C zu einem vorgesinterten Werkstoff;
- Pulverisieren des vorgesinterten Werkstoffs in einen vorgesinterten Pulverwerkstoff;
umfasst, und dass der so gewonnene und vorgesinterte Pulverwerkstoff als Target benutzt wird.

3. Verfahren zur Herstellung eines dünnen Films eines supraileitenden Oxids mit einer Kristallstruktur eines Perowskit- oder Quasiperowskit-Aufbaus durch physikalische Abscheidung aus der Dampfphase (PVD) auf einem Substrat, **dadurch gekennzeichnet, dass** bei der physikalischen Abscheidung aus der Dampfphase (PVD) ein Target benutzt wird, welches aus einem Verbundoxid besteht, das Ba; ein Element M aus der aus Y, Gd, Ho, Er und Yb bestehenden Gruppe; und Cu enthält;
und dass die Vorbereitung des Targets die Schritte:
- Vorbereiten einer Pulvermischung eines Oxids, Carbonats, Nitrats oder Sulfats von Ba; eines Oxids, Carbonats, Nitrats oder Sulfats eines der Elemente M aus Y, Gd, Ho, Er und Yb bestehenden Gruppe; und eines Oxids, Carbonats, Nitrats oder Sulfats von Cu,
- Vorsintern dieser Pulvermischung bei einer Temperatur im Bereich von 250 bis 1200 °C zu einem vorgesinterten Werkstoff;
- Pulverisieren des vorgesinterten Werkstoffs;
- Nachsintern des nach dem Pulverisieren erhaltenen vorgesinterten Werkstoffs bei einer Temperatur im Bereich zwischen 700 und 1500 °C, vorzugsweise zwischen 700 bis 1300 °C;
- Pulverisieren des durch das Nachsintern erhaltenen nachgesinterten Werkstoffs zu einem nachgesinterten Pulverwerkstoff umfasst, und dass der so gewonnene und nachgesinterte Pulverwerkstoff als Target benutzt wird.

4. Verfahren nach Anspruch 1, **dadurch gekennzeichnet, dass** das Target ein Oxid vom Perowskit- oder Quasi-Perowskit-Typ enthält.

5. Verfahren nach Anspruch 1 oder 4, **dadurch gekennzeichnet, dass** das Target aus einer Vielzahl von Target-Segmenten zusammengesetzt ist.

6. Verfahren nach Anspruch 5, **dadurch gekennzeichnet, dass** jedes der Target-Segmente aus einem Oxid von Ba; einem Oxid eines der Elemente M aus der aus Y, Gd, Ho, Er und Yb bestehenden Gruppe oder einem Oxid von Cu besteht.

7. Verfahren nach einem der Ansprüche 1, 4, 5 oder 6, **dadurch gekennzeichnet, dass** ein Atomverhältnis Ba/(Ba+M) im Bereich von 0,04 bis 0,97 liegt, wobei M für eines der Elemente M aus der aus Y, Gd, Ho, Er und Yb bestehenden Gruppe steht.

8. Verfahren nach einem der Ansprüche 1, 4, 5, 6 oder 7, **dadurch gekennzeichnet, dass** ein Atomverhältnis Ba/(Ba+M) im Bereich von 0,1 bis 0,7 liegt, wobei M für eines der Elemente M aus der aus Y, Gd, Ho, Er und Yb bestehenden Gruppe steht.

9. Verfahren nach Anspruch 2 oder 3, **dadurch gekennzeichnet, dass** das Target ein Oxid vom Perowskit- oder Quasi-Perowskit-Typ enthält.

10. Verfahren nach einem der Ansprüche 2, 3 oder 9, **dadurch gekennzeichnet, dass** das Target aus einer Vielzahl von Target-Segmenten zusammengesetzt ist.

11. Verfahren nach Anspruch 10, **dadurch gekennzeichnet, dass** jedes der Target-Segmente aus einem Oxid von Ba; einem Oxid eines der Elemente M aus der aus Y, La, Gd, Ho, Er und Yb bestehenden Gruppe oder einem Oxid von Cu besteht.

12. Verfahren nach einem der Ansprüche 2, 3, 9, 10 oder 11, **dadurch gekennzeichnet, dass** ein Atomverhältnis Ba/(Ba+M) im Bereich von 0,04 bis 0,97 liegt, wobei M für eines der Elemente M aus der aus Y, La, Gd, Ho, Er und Yb bestehenden Gruppe steht.

13. Verfahren nach einem der Ansprüche 2, 3, 9, 10, 11 oder 12, **dadurch gekennzeichnet, dass** ein Atomverhältnis Ba/(Ba+M) im Bereich von 0,1 bis 0,7 liegt, wobei M für eines der Elemente M aus der aus Y, La, Gd, Ho, Er und Yb bestehenden Gruppe steht.

14. Verfahren nach einem der Ansprüche 1 bis 13, **dadurch gekennzeichnet, dass** ein Atomverhältnis von Ba, M und Cu in Abhängigkeit der Verdampfungsraten von Ba, M und Cu auf der Grundlage des im dünnen Film herzustellenden Atomverhältnisses Ba, M, Cu eingestellt wird.

15. Verfahren nach einem der Ansprüche 1 bis 14, **dadurch gekennzeichnet, dass** Ar und O₂ in einer Verdampfungsatmosphäre enthalten sind, wobei der Partialdruck von Ar im Beeich von 1,33 ∗ 10⁻¹ Pa bis 1,33 ∗ 10¹ Pa, vorzugsweise von 6,67 ∗ 10⁻¹ Pa bis 1,33 ∗ 10¹ Pa (1,0 ∗ 10⁻³ Torr bis 1,0 ∗ 10⁻¹ Torr, vorzugsweise 5,0 ∗ 10⁻³ Torr bis 1 ∗ 10⁻¹ Torr) liegt.

16. Verfahren nach einem der Ansprüche 1 bis 15, **dadurch gekennzeichnet, dass** O₂ in der Verdampfungsatmosphäre einen Partialdruck im Bereich von 6,67 ∗ 10⁻² Pa bis 1,33 ∗ 10¹ Pa, vorzugsweise von 1,33 ∗ 10⁻¹ Pa bis 1,33 ∗ 10¹ Pa (0,5 ∗ 10⁻³ Torr bis 1,0 ∗ 10⁻¹ Torr, vorzugsweise 1,0 ∗ 10⁻³ Torr bis 1 ∗ 10⁻¹ Torr) besitzt.

17. Verfahren nach einem der Ansprüche 1 bis 16, **dadurch gekennzeichnet, dass** die physikalische Abscheidung aus der Dampfphase (PVD) nach einer Hochfrequenz-Sputter-Methode erfolgt, wobei die Hochfrequenzleistung geringer als 115 W/cm², vorzugsweise geringer als 15 W/cm² ist.

18. Verfahren nach Anspruch 17, **dadurch gekennzeichnet, dass** die physikalische Abscheidung aus der Dampfphase (PVD) durch Magnetron-Sputtern erfolgt.

19. Verfahren nach einem der Ansprüche 1 bis 18, **dadurch gekennzeichnet, dass** der erhaltene dünne Film weitergehend wärmebehandelt wird.

20. Verfahren nach Anspruch 19, **dadurch gekennzeichnet, dass** die Wärmebehandlung bei einer Temperatur im Bereich von 250 °C bis 1700 °C, vorzugsweise im Bereich von 250 °C bis 1200 °C, durchgeführt wird.

21. Verfahren nach Anspruch 19 oder 20, **dadurch gekennzeichnet, dass** die Wärmebehandlung unter einem Partialdruck von O₂ durchgeführt wird, der nicht höher als 6,67 Pa (0,5 ∗ 10⁻¹ Torr) liegt.

22. Verfahren nach einem der Ansprüche 1 bis 21, **dadurch gekennzeichnet, dass** während des Sputtervorgangs mittels eines Heizers ein Substrat aufgeheizt wird.

23. Verfahren nach Anspruch 22, **dadurch gekennzeichnet, dass** das Substrat während des Sputtervorgangs auf eine Temperatur im Bereich von 184 °C bis 1520 °C, vorzugsweise im Bereich von 184 °C bis 1000 °C, aufgeheizt wird.

24. Verfahren nach einem der Ansprüche 1 bis 23, **dadurch gekennzeichnet, dass** das Substrat aus einem Werkstoff aus einer aus Glas, Quarz, Silicium, rostfreiem Stahl und Keramik bestehenden Gruppe hergestellt ist.

25. Verfahren nach einem der Ansprüche 1 bis 24, **dadurch gekennzeichnet, dass** der Abstand zwischen dem Substrat und dem Target auf einen Wert von 3 bis 300 mm, vorzugsweise von 15 bis 300 mm, eingestellt ist.

26. Verfahren nach einem der Ansprüche 1 bis 16, **dadurch gekennzeichnet, dass** die physikalische Abscheidung aus der Dampfphase (PVD) nach einer Ionen-Plattierungs-Methode erfolgt.

27. Verfahren nach einem der Ansprüche 1 bis 16, **dadurch gekennzeichnet, dass** die physikalische Abscheidung aus der Dampfphase (PVD) entweder durch Vakuumabscheidung, Ionenstrahlabscheidung oder Molekularstrahlabscheidung erfolgt.

## Revendications

1. Un procédé de production d'une couche mince d'un oxyde supraconducteur, présentant la structure cristalline correspondant à une structure perovskite ou quasi-perovskite, par dépôt en phase vapeur sur un substrat, **caractérisé en ce que** l'on utilise une cible, pour ledit dépôt en phase vapeur, réalisée en un composé à base d'oxyde contenant du Ba ; un élément M choisi dans le groupe composé de Y, Gd, Ho, Er et Y ; et Cu ; **en ce que** la préparation de ladite cible comprend les étapes consistant :
- à préparer un mélange poudreux d'un oxyde, d'un carbonate, d'un nitrate ou d'un sulfate de Ba ; d'un oxyde, carbonate, nitrate ou sulfate d'un élément M choisi dans le groupe composé de Y, Gd, Ho, Er et Yb ; et d'un oxyde, carbonate, nitrate ou sulfate de Cu ; et
- à soumettre à un frittage préliminaire ledit mélange poudreux à une température allant de 250° C à 1200° C, pour obtenir un matériau préfritté ;
et **en ce que** l'on utilise comme cible le matériau préfritté ainsi obtenu.

2. Un procédé de production d'une couche mince d'un oxyde supraconducteur, présentant la structure cristalline correspondant à une structure perovskite ou quasi-perovskite, par dépôt en phase vapeur sur un substrat, **caractérisé en ce que** l'on utilise une cible, pour ledit dépôt en phase vapeur, réalisée en un composé à base d'oxyde contenant du Ba ; un élément M choisi dans le groupe composé de Y, La, Gd, Ho, Er et Yb ; et Cu ; **en ce que** la préparation de ladite cible comprend les étapes consistant :
- à préparer un mélange poudreux d'un oxyde, d'un carbonate, d'un nitrate ou d'un sulfate de Ba ; d'un oxyde, carbonate, nitrate ou sulfate d'un élément M choisi dans le groupe composé de Y, La, Gd, Ho, Er et Yb ; et d'un oxyde, carbonate, nitrate ou sulfate de Cu ;
- à soumettre à un frittage préliminaire ledit mélange poudreux à une température allant de 250° C à 1200° C, pour obtenir un matériau préfritté ;
- à pulvériser le matériau préfritté en un matériau préfritté en poudre ; et **en ce que** l'on utilise comme cible le matériau préfritté ainsi obtenu.

3. Un procédé de production d'une couche mince d'un oxyde supraconducteur, présentant la structure cristalline correspondant à une structure perovskite ou quasi-perovskite, par dépôt en phase vapeur sur un substrat, **caractérisé en ce que** l'on utilise une cible, pour ledit dépôt en phase vapeur, réalisée en un composé à base d'oxyde contenant du Ba ; un élément M choisi dans le groupe composé de Y, La, Gd, Ho, Er et Yb ; et Cu ; **en ce que** la préparation de ladite cible comprend les étapes consistant :
- à préparer un mélange poudreux d'un oxyde, d'un carbonate, d'un nitrate ou d'un sulfate de Ba ; d'un oxyde, carbonate nitrate ou sulfate d'un élément M choisi dans le groupe composé de Y, La, Gd, Ho, Er et Yb ; et d'un oxyde, carbonate, nitrate ou sulfate de Cu ;
- à soumettre à un frittage préliminaire ledit mélange poudreux à une température allant de 250° C à 1200° C, pour obtenir un matériau préfritté ;
- à pulvériser le matériau préfritté ;
- à soumettre le matériau préfritté obtenu après ladite pulvérisation à un frittage final, effectué à une température allant de 700° C à 1500° C, de préférence de 700° C à 1300° C ;
- à pulvériser le matériau fritté final obtenu par le frittage final en un matériau poudreux fritté final ;
et **en ce que** le matériau poudreux fritté final ainsi obtenu est utilisé comme cible.

4. Un procédé selon la revendication 1 **caractérisé en ce que** ladite cible contient un oxyde de type perovskite ou un oxyde de type quasi-perovskite.

5. Un procédé selon la revendication 1 ou 4, **caractérisé en ce que** ladite cible est composée d'une pluralité de segments de cible.

6. Un procédé selon la revendication 5, **caractérisé en ce que** chacun desdits segments de cible est composé d'un oxyde de Ba, un oxyde d'un élément M choisi dans le groupe composé de Y, Gd, Ho, Er et Yb, ou un oxyde de Cu.

7. Un procédé selon l'une quelconque des revendications 1, 4, 5 ou 6 **caractérisé en ce que** le rapport atomique Ba/(Ba+M) est compris dans l'intervalle de 0,04 à 0,97, où M représente un élément M choisi dans le groupe composé de Y, Gd, Ho, Er et Yb.

8. Un procédé selon l'une quelconque des revendications 1, 4, 5, 6 ou 7, **caractérisé en ce que** le rapport atomique Ba/(Ba+M) est compris dans l'intervalle de 0,1 à 0,7, où M représente un élément M choisi dans le groupe composé de Y, Gd, Ho, Er et Yb.

9. Un procédé selon la revendication 2 ou 3, **caractérisé en ce que** ladite cible contient un oxyde de type perovskite ou un oxyde de type quasi-perovskite.

10. Un procédé selon l'une quelconque des revendications 2, 3 ou 9, **caractérisé en ce que** ladite cible est composée d'une pluralité de segments de cible.

11. Un procédé selon la revendication 10, **caractérisé en ce que** chacun desdits segments de cible est composé d'un oxyde de Ba, un oxyde d'un élément M choisi dans le groupe composé de Y, La, Gd, Ho, Er et Yb, ou un oxyde de Cu.

12. Un procédé selon l'une quelconque des revendications 2, 3, 9, 10 ou 11 **caractérisé en ce que** le rapport atomique Ba/(Ba+M) est compris dans l'intervalle de 0,04 à 0,97, où M représente un élément M choisi dans le groupe composé de Y, La, Gd, Ho, Er et Yb.

13. Un procédé selon l'une quelconque des revendications 2, 3, 9, 10, 11 ou 12 en ce que le rapport atomique Ba/(Ba+M) est compris dans l'intervalle de 0,1 à 0,7, où M représente un élément M choisi dans le groupe composé de Y, La, Gd, Ho, Er et Yb.

14. Un procédé selon l'une quelconque des revendications 1 à 13, **caractérisé en ce que** le rapport atomique de Ba, M et Cu de ladite cible est réglé en fonction des vitesses d'évaporation de Ba, M et Cu sur la base du rapport atomique de Ba, M et Cu dans une couche mince à réaliser.

15. Un procédé selon l'une quelconque des revendications 1 à 14, **caractérisé en ce qu'**une atmosphère de vaporisation contient Ar et O₂, la pression partielle de Ar allant de 1,33 x 10⁻¹ Pa à 1,33 x 10¹ Pa, de préférence de 6,67 x 10⁻¹ Pa à 1,33 x 10¹ Pa (1,0 x 10⁻³ à 1 x 10⁻¹ Torr, de préférence 5,0 x 10⁻³ à 1 x 10⁻¹ Torr).

16. Un procédé selon l'une quelconque des revendications 1 à 15, **caractérisé en ce que** O₂ dans l'atmosphère de vaporisation présente une pression partielle comprise allant de 6,67 x 10⁻² Pa à 1,33 x 10¹ Pa, de préférence de 1,33 x 10⁻¹ Pa à 1,33 x 10¹ Pa (0,5 x 10⁻³ à 1 x 10⁻¹ Torr, de préférence 1,0 x 10⁻³ à 1 x 10⁻¹ Torr).

17. Un procédé selon l'une quelconque des revendications 1 à 16, **caractérisé en ce que** le dépôt en phase vapeur est réalisé par une technique de pulvérisation cathodique à haute fréquence, la puissance de la haute fréquence étant inférieure à 115 W/cm⁻², de préférence inférieure à 15 W/cm⁻².

18. Un procédé selon la revendication 17, **caractérisé en ce que** ledit dépôt en phase vapeur est réalisé par pulvérisation à l'aide d'un magnétron.

19. Un procédé selon l'une quelconque des revendications 1 à 18, **caractérisé en ce qu'**on soumet la couche mince obtenue à un traitement thermique ultérieur.

20. Un procédé selon la revendication 19, **caractérisé en ce que** ledit traitement thermique est réalisé à une température allant de 250° C à 1700° C, de préférence de 250° C à 1200° C.

21. Un procédé selon la revendication 19 ou 20, **caractérisé en ce que** ledit traitement thermique est réalisé sous une pression partielle de O₂ qui n'est pas supérieure à 6,67 Pa (0,5 x10⁻¹ Torr).

22. Un procédé selon l'une quelconque des revendications 1 à 21, **caractérisé en ce qu'**on chauffe un substrat au moyen d'un dispositif de chauffage pendant l'opération de pulvérisation cathodique.

23. Un procédé selon la revendication 22, **caractérisé en ce que** ledit substrat est chauffé à une température allant de 184° C à 1520° C, de préférence, 184° C à 1000° C, pendant l'opération de pulvérisation cathodique.

24. Un procédé selon l'une quelconque des revendications 1 à 23, **caractérisé en ce que** ledit substrat est réalisé en l'un des matériaux choisis dans le groupe composé de verre, quartz, silicium, acier inoxydable et céramiques.

25. Un procédé selon l'une quelconque des revendications 1 à 24, **caractérisé en ce que** la distance entre ledit substrat et ladite cible est réglée à une valeur comprise entre 3 et 300 mm, de préférence entre 15 et 300 mm.

26. Un procédé selon l'une quelconque des revendications 1 à 16, **caractérisé en ce que** ledit dépôt en phase vapeur est réalisé par une technique de plaquage ionique.

27. Un procédé selon l'une quelconque des revendications 1 à 16, **caractérisé en ce que** ledit dépôt en phase vapeur est réalisé par l'un des procédés choisis parmi le dépôt sous vide, le dépôt par faisceau ionique ou le dépôt par faisceau moléculaire.
